(19) Europäisches Patentamt
European Patent Office
Office européen des brevets

(11) **EP 1 705 419 B1**

(12) **EUROPÄISCHE PATENTSCHRIFT**

(45) Veröffentlichungstag und Bekanntmachung des Hinweises auf die Patenterteilung:
**30.09.2009 Patentblatt 2009/40**

(51) Int Cl.:
***F17C 13/08*** *(2006.01)*

(21) Anmeldenummer: **06005012.7**

(22) Anmeldetag: **11.03.2006**

(54) **Kryostatanordnung mit thermisch kompensierter Zentrierung**

Mounting arrangement for cryostat with themically compensated centering

Dispositif de montage pour cryostat avec centrage à compensation de température

(84) Benannte Vertragsstaaten:
**CH DE FR GB LI**

(30) Priorität: **24.03.2005 DE 102005013620**

(43) Veröffentlichungstag der Anmeldung:
**27.09.2006 Patentblatt 2006/39**

(73) Patentinhaber: **Bruker BioSpin AG**
**8117 Fällanden (CH)**

(72) Erfinder:
• **Mraz, Beat**
**6808 Bubikon (CH)**

• **Bösel, Johannes, Dr.**
**6345 Neuheim (CH)**

(74) Vertreter: **Kohler Schmid Möbus**
**Patentanwälte**
**Ruppmannstraße 27**
**70565 Stuttgart (DE)**

(56) Entgegenhaltungen:
**EP-A- 0 014 250     WO-A-20/06096897**
**GB-A- 2 348 693     US-A- 3 245 571**
**US-A- 3 347 402     US-A- 3 425 584**
**US-A- 3 814 361     US-A- 4 038 832**

**Beschreibung**

Die Erfindung betrifft eine Kryostatanordnung zur Aufbewahrung von kryogenen Fluiden in mindestens einem Kryobehälter, welcher an thermisch isolierenden Aufhängerohren und/oder Aufhängevorrichtungen aufgehängt ist, die mit einem Außenmantel der Kryostatanordnung verbunden sind, wobei der mindestens eine Kryobehälter thermischen Effekten unterworfen ist und mit Hilfe von mindestens drei über den Umfang des Kryobehälters verteilten Zentrierelementen gegen einen weiter außen liegenden Behälter, vorzugsweise den Außenmantel, zentriert wird, wobei die Zentrierelemente jeweils mit einem Ende am weiter außen liegenden Behälter anliegen oder befestigt sind. Eine Kryostatanordnung ist beispielsweise aus EP 001 4 250, welches als nächstliegender Stand der Technik anzusehen ist, bekannt. Eine derartige Kryostatanordnung ist für ein supraleitendes Magnetsystem einer Messeinrichtung zur Kernspinresonanz (NMR) zum Beispiel aus DE 29 06 060 A1 oder der Druckschrift ,Superconducting NMR Magnet Design' (Concepts in Magnetic Resonance, 1993, 6, 255-273) bekannt. Das supraleitende Magnetspulensystem ist in einem ersten Kryobehälter mit kryogener Flüssigkeit, üblicherweise flüssigem Helium, angeordnet, welcher von Strahlungsschilden, Superisolationsfolien und gegebenenfalls einem weiteren Kryobehälter mit kryogener Flüssigkeit, üblicherweise flüssigem Stickstoff, umgeben ist. Die Flüssigkeitsbehälter, Strahlungsschilde und Superisolationsfolien sind in einem äußeren Behälter untergebracht, welcher einen Vakuumraum begrenzt (=äußere Vakuumhülle, Außenmantel). Der supraleitende Magnet wird durch das verdampfende, ihn umgebende Helium-gekühlt und auf konstanter Temperatur gehalten. Die den Heliumbehälter umgebenden Elemente dienen der Wärmeisolierung des Heliumbehälters, so dass der Wärmeeinfall auf den Heliumbehälter minimiert wird und die Abdampfrate des Heliums klein bleibt.

Magnetsysteme zur hochauflösenden NMR-Spektroskopie sind in der Regel so genannte Vertikalsysteme, bei denen die Öffnung zur Aufnahme der zu untersuchenden NMR-Probe und der homogene Bereich der Magnetfeldlinien in vertikaler Richtung verlaufen. Sämtliche ineinander verschachtelte Kryobehälter und der Außenmantel weisen somit jeweils ein Innenrohr auf. Der Heliumbehälter ist gewöhnlicherweise an mindestens zwei dünnwandigen Aufhängerohren mit der äußeren Vakuumhülle verbunden. Zum einen wird der Kryobehälter somit mechanisch fixiert, zum anderen bieten die Aufhängerohre Zugang zum Magneten, wie es z. B. beim Abkühlen und Laden notwendig ist. Damit sich verschiedene Kryobehälter, die sich auf unterschiedlichen Temperaturniveaus befinden, nicht berühren (und somit Wärmebrücken entstehen und erhöhte Verluste der Kryogene auftreten), werden sie radial durch auf Druck oder Zug belastete Zentrierelemente abgestützt. Diese umfassen möglichst lange, dünne Stäbe aus einem schlecht wärmeleitenden Material, welche zum Beispiel fest mit dem Heliumbehälter verbunden sind, den Stickstoffbehälter aber nur punktförmig berühren. Der Stickstoffbehälter ist in diesem Fall wiederum über ähnliche Zentrierelemente mit der äußeren Vakuumhülle verbunden und auf diese Weise zentriert. Bei rotationssymmetrisch ausgebildeten Vertikalkryostaten kleinerer Dimension ist der Einbau von auf Druck belasteter Zentrierungen üblich. Gegenüber Zugzentrierungen haben diese unter Anderem den Vorteil, dass keine zusätzlichen festen Verankerungen am zweiten Kryobehälter oder der äußeren Vakuumhülle notwendig werden und somit die konstruktive Ausführung einfacher wird.

Beim Abkühlen kontrahieren die Kryobehälter mehr oder weniger stark (abhängig von ihrer endgültigen Betriebstemperatur), während die äußere Vakuumhülle auf Raumtemperatur bleibt und ihre Abmaße beibehält. Hierdurch können die Behälter ihre Position zueinander und in Bezug auf den Außenmantel verändern. Es besteht die Gefahr, dass sich zwei Behälter - und hier vor allem, im Bereich ihrer Innenrohre - berühren und sich Wärmebrücken ausbilden, was zu erhöhten Verlustraten an Kryogenen führt. Die eingesetzten Zentrierelemente sollen dies verhindern. Da jedoch die Zentrierelemente in der Regel beim Abkühlen auch kontrahieren und sich die Behälter nicht im kalten Zustand zueinander ausrichten lassen können, müssen die Elemente im warmen Zustand vorgespannt werden (bei Druckzentrierungen) bzw. sind die Elemente nach Abkühlen stärker belastet als im warmen Zustand (bei Zugzentrierungen). Diesem veränderten und nicht definierten Spannungszustand muss bei der Auslegung der Elemente Rechnung getragen werden.

Diese Problematik verschärft sich, wenn z.B. bei Vertikalkryostaten zusätzlich zu den Aufhängerohren asymmetrisch angebrachte, vertikale Öffnungen (Halsrohre) zwischen Heliumbehälter oder Stickstoffbehälter und der äußeren Vakuumhülle notwendig werden, zum Beispiel dann, wenn ein Kryokühler zur Rekondensation von verdampfenden Kryogenen eingesetzt wird. In diesem Fall verbindet oben genanntes Halsrohr die äußere Vakuumhülle des Kryostaten mit dem Kryobehälter, wie es beispielsweise in der Druckschrift US2002/0002830 für einen Heliumbehälter beschrieben wird. Sind diese Öffnungen vertikal elastisch ausgeführt (z.B. als Wellbalg), resultiert aus den Kräften, die durch das Evakuieren des Zwischenraumes zwischen der äußeren Vakuumhülle und den Einbauten des Kryostaten entstehen, ein Drehmoment auf den Behälter. Dieses Drehmoment muss nun durch die Zentrierungen am unteren und oberen Rand der Kryobehälter bereits im warmen Zustand aufgefangen werden. Damit die Behälter auch im kalten Zustand noch zentriert bleiben, müssen die Zentrierelemente auf der einen Seite des Behälters im warmen Zustand noch stärker vorgespannt werden (Druckzentrierungen) bzw. weisen im kalten Zustand eine noch höhere Spannung auf (Zugzentrierungen) als für Behälter ohne asymmetrische Öffnung. Durch die exzentrische Vorspannung kann es zu Berührungen der Behälter untereinander, vor allem im Bereich der Innenrohre, kommen. Daraus resultieren dann während des Abkühlens größere Verluste an Kryogenen und unter Umständen kommt es sogar zu einem Vakuumbruch, wenn O-Ringe ausfrieren und ihre abdichtenden Eigenschaften verlieren.

Aufgabe der vorliegenden Erfindung ist es daher, eine Kryostatanordnung vorzuschlagen, bei der Zentrierelemente zwischen dem zu zentrierenden Behälter und einem weiter außen liegenden Behälter, vorzugsweise der äußeren Vakuumhülle, eingesetzt werden, so dass die Behälter stets zueinander zentriert bleiben und die Zentrierelemente in keinem Betriebszustand überbelastet werden.

Aufgabe der vorliegenden Erfindung ist es daher, eine Kryostatanordnung vorzuschlagen, die selbst nach Abkühlen der Kryobehälter ohne Überbelastung der Zentrierelemente eine Druckzentrierung erlaubt, so dass sich die verschiedenen Kryobehälter beziehungsweise der Kryobehälter und der Außenmantel nicht berühren.

Diese Aufgabe wird erfindungsgemäß dadurch gelöst, dass bei mindestens einem der Kryobehälter die Zentrierelemente an ihrem dem Außenmantel abgewandten Enden jeweils mit einem Aktuator verbunden sind, der auf das jeweilige Zentrierelement eine Druckoder Zugkraft ausübt, und der mindestens an einem Kontaktpunkt an dem Kryobehälter montiert ist, wobei durch die Fixierung des Aktuators am Kontaktpunkt am Kryobehälter sowie durch die thermisch bedingte Veränderungen der Abmaße des Kryobehälters und die thermisch bedingten Veränderungen der Abmaße einzelner Bauelemente des Aktuators und gegebenenfalls durch eine mechanische Übersetzung eine mechanische Spannung in den entsprechenden Zentrierelementen erzeugt wird, so dass die Zentrierelemente unabhängig von den Temperaturen innerhalb der Kryostatanordnung stets auf einen nahezu konstanten Druck oder Zug, vorzugsweise im Bereich $\pm$ 10% des bei Raumtemperatur herrschenden Drucks oder Zugs, belastet werden.

Entscheidend hierbei ist das Zusammenspiel der thermische bedingten Veränderung des Kryobehälters, die sich im Allgemeinen als Kontraktion desselben bemerkbar macht, und die thermisch bedingte Längenänderung der Bauteile des Aktuators, der an mindestens einem geeigneten Kontaktpunkt mit dem Kryobehälter verbunden ist. Über den oder die Kontaktpunkte wird die aus der Änderung der Abmaße resultierende Bewegung des Kryobehälters auf den Aktuator übertragen. Die aus der Kontraktion des Kryobehälters resultierende Abstandsvergrößerung zwischen den Kontaktpunkten des Aktuators am Kryobehälter und dem weiter außen liegenden Behälter; vorzugsweise dem Außenmantel, gegen den der Kryobehälter zentriert werden soll, wird durch eine Änderung der Länge von Bauteilen des Aktuators ausgeglichen. Dies wird möglich, wenn Materialien mit unterschiedlichen thermischen Ausdehnungskoeffizienten und/ oder unterschiedlichen Abmessungen geometrisch so miteinander kombiniert werden, dass sich die Position der Verbindungsstelle des Aktuators mit dem Zentrierelement in Bezug auf den weiter außen liegenden Behälter (Außenmantel) nicht oder nur unwesentlich ändert. Auf diese Weise erfahren die Zentrierelemente, unabhängig von der gerade herrschenden Temperatur, immer in etwa die selbe Druck- oder Zugbelastung, so dass die Zentrierelemente stets einen ähnlichen, klar definierten Spannungszustand aufweisen, wobei der Kryobehälter in seiner zentralen Lage bleibt.

Das Auszentrieren der Behälter ist im warmen Zustand leicht möglich und während des Abkühlens treten zu keinem Moment Berührungen der Behälter miteinander auf. Außerdem ist es dann möglich, für jede Art von Behältern die erfindungsgemäßen konstruktiv weniger aufwendigen Druckzentrierungen einzusetzen.

Die Vorteile der Erfindung kommen besonders gut zur Geltung, wenn der Kryobehälter eine zusätzliche, asymmetrische Öffnung nach außen aufweist. Das aus der oben beschriebenen Evakuierung des Zwischenraumes zwischen der äußeren Vakuumhülle und den Einbauten des Kryostaten durch die asymmetrischen Öffnung entstehende zusätzliche Drehmoment auf den Kryobehälter kann durch die erfindungsgemäße Kryostatanordnung, auch im kalten Zustand, ohne zusätzliche Belastungen aufgefangen werden.

Eine spezielle Ausführungsform der erfindungsgemäßen Kryostatanordnung sieht vor, dass zumindest eines der Zentrierelemente über ein die Wärme gut leitendes und flexibles Verbindungselement mit einem weiteren Kryobehälter oder einem Strahlungsschild, der sich zwischen dem zu zentrierenden Kryobehälter und dem weiter außen liegenden Behälter, vorzugsweise dem Außenmantel, befindet, thermisch kontaktiert ist. Der Wärmeeintrag, beispielsweise vom Außenmantel auf den Kryobehälter, kann auf diese Weise reduziert werden.

Bei einer bevorzugten Ausführungsform der erfindungsgemäßen Kryostatanordnung sind die Zentrierelemente aus glasfaserverstärktem Kunststoff oder einem Material ähnlicher thermischer und mechanischer Eigenschaften gefertigt. Für die Zentrierelemente sind insbesondere eine geringe thermische Leitfähigkeit, eine hohe Druck- oder Zugfestigkeit und eine hohe Biegeelastizität wichtig, um einerseits einen unnötigen Wärmeeintrag beispielsweise vom Außenbehälter zu vermeiden und andererseits um der Druck- beziehungsweise Zugbelastung, denen die Zentrierelemente ausgesetzt sind, standzuhalten.

Vorzugsweise sind die Zentrierelemente jeweils als Rohr oder Stab mit einem beliebigen, insbesondere variablen, Querschnitt ausgebildet. Um den Wärmeeintrag auf den Kryobehälter gering zu halten, empfiehlt es sich, die Zentrierelemente möglichst dünn zu dimensionieren.

Bei einer besonders bevorzugten Ausführungsform der erfindungsgemäßen Kryostatanordnung umfasst der Aktuator ein erstes und ein zweites Bauelement, wobei die Bauelemente aus Materialien von unterschiedlichen thermischen Ausdehnungskoeffizienten gefertigt sind. Bei einer Temperaturänderung beider Bauelemente werden sich somit im Allgemeinen unterschiedliche Längenänderungen ergeben, so dass sich die Bauelemente relativ zueinander bewegen können. Die Wahl der Materialien der Bauelemente, insbesondere hinsichtlich der Längenausdehnungskoeffizienten, ist dabei-abhängig von der Gestaltung des Aktuators und der geometrischen Gesamtanordnung der einzelnen Elemente der Kryostatanordnung. Es ist darüber hinaus auch vorstellbar, dass die Bauteile zwar aus dem gleichen Material gefertigt sind, aufgrund ihrer unterschiedlichen Länge aber bei Abkühlung eine unterschiedliche absolute Längenänderung erfahren.

Vorzugsweise ist das erste Bauelement des Aktuators aus einem Material mit einem thermischen Ausdehnungskoeffizienten gefertigt, der kleiner oder gleich Null ist. Bei einer Abkühlung bleibt das Bauelement somit gleich lang oder dehnt sich sogar aus.

Ebenso ist es möglich, dass das erste Bauelement des Aktuators aus einem Material mit einem positiven thermischen Ausdehnungskoeffizienten gefertigt ist, dessen Betrag so gewählt ist, dass bei einer Temperaturänderung die absolute Längenänderung des ersten Bauelements weniger als die absolute Längenänderung des zweiten Bauelements, vorzugsweise höchstens ein Fünftel der absoluten Längenänderung des zweiten Bauelements, beträgt. Es ergibt sich dann eine noch ausreichende Längendifferenz der Bauelemente, um die Änderung des Abstands des Kryobehälters gegenüber dem Behälter, gegen den der Kryobehälter zentriert werden soll, auszugleichen. Der hierfür relevante Temperaturbereich erstreckt sich von Raumtemperatur bis zur Temperatur des im Kryobehälter aufbewahrten kryogenen Fluids, bei flüssigem Helium beispielsweise bis etwa 4K.

Das erste Bauelement des Aktuators ist vorzugsweise als Rohr oder Stab mit einem beliebigen, insbesondere variablen, Querschnitt ausgebildet.

Besonders vorteilhaft ist es, wenn das zweite Bauelement des Aktuators aus einem Material mit einem großen positiven thermischen Ausdehnungskoeffizienten gefertigt ist, insbesondere aus Kupfer, Messing, Aluminium oder einem Material ähnlicher thermischer und mechanischer Eigenschaften, so dass eine Abkühlung des zweiten Bauelements eine starke Verkürzung desselben hervorruft.

Das zweite Bauelement des Aktuators ist vorzugsweise als einseitig geschlossenes Rohr oder einseitig geschlossener Kanal ausgebildet.

Eine besonders bevorzugte Ausführungsform sieht vor, dass das erste Bauelement des Aktuators innerhalb des als Rohr oder Kanal ausgebildeten zweiten Bauelements des Aktuators, insbesondere koaxial, angeordnet ist.

Bei einer vorteilhaften Weiterbildung dieser Ausführungsform ist das erste Bauelement des Aktuators mit dem als Rohr oder Kanal ausgebildeten zweiten Bauelement des Aktuators am geschlossenen Rohrende des zweiten Bauelements über eine axiale Schraubverbindung verschiebbar verbunden, derartig, dass das erste Bauelement in Bezug auf das zweite Bauelement in Richtung der Rohrachse verschoben werden kann. Durch die Verbindung der beiden Elemente wird bewirkt, dass sich eine Längenänderung oder Verschiebung des einen Elements auf das andere auswirkt. Die Schraubverbindung ermöglicht zudem, die Elemente gegenüber dem weiter außen liegenden Behälter, vorzugsweise dem Außenmantel, bereits im warmen Zustand vorzuspannen.

Um bei einer Verschiebung des ersten Bauelements gegenüber dem zweiten Bauelement in Richtung der Achse des Zentrierelements eine zu starke Durchbiegung des ersten Bauelements bzw. eine zu starke Biegebeanspruchung an der Verbindungsstelle der beiden Bauelemente zu vermeiden, ist es vorteilhaft, wenn um das erste Bauelement des Aktuators eine Führungshülse angebracht ist, welche fest auf dem ersten Bauelement sitzt und deren Außendurchmesser so groß ist, dass zwischen der Führungshülse und dem zweiten Bauelement ein Spiel bestehen bleibt. Ebenso kann eine Führungshülse fest mit der Innenseite des zweiten Bauelements verbunden sein.

Bei einer bevorzugten Ausführungsform der Erfindung ist das als Rohr oder Kanal ausgebildete zweite Bauelement des Aktuators am oder in der Nähe seines offenen Rohrendes mit dem gegenüber dem weiter außen liegenden Behälter zu zentrierenden Kryobehälter an einem Kontaktpunkt, vorzugsweise in der Nähe des äußeren Randes des Kryobehälters, fest verbunden. Das nicht mit dem zu zentrierenden Kryobehälter verbundene Ende des zweiten Bauelements des Aktuators befindet sich dann näher an der Achse des Kryobehälters als der Kontaktpunkt. Die temperaturbedingte Längenänderung der Bauelemente bewirkt somit, dass sich das Ende des ersten Bauelements, welches nicht mit dem zweiten Bauelement verbunden ist, relativ zum Behälter, gegen den zentriert werden soll, bewegt, und zwar entgegen gesetzt zu der temperaturbedingten Bewegung des zu zentrierenden Kryobehälters. Auf diese Weise ist ein Ausgleich der temperaturbedingten Abstandsänderungen des Kryobehälters zu dem Behälter, gegen den zentriert werden soll, möglich.

Um diese Bewegung auf das Zentrierelement zu übertragen, ist das erste Bauelement des Aktuators an einem Ende, welches nicht mit dem zweiten Bauelement verbunden ist, mit dem Zentrierelement fest verbunden.

Für die Übertragung der Bewegung der Bauelemente auf das Zentrierelement kann es vorteilhaft sein, wenn der Aktuator zusätzlich ein mechanisches Übersetzungselement umfasst, insbesondere einen Hebel, ein Zahnrad oder einen Exzenter, welches mit dem zu zentrierenden Kryobehälter an einem Kontaktpunkt in der Nähe des äußeren Randes des Kryobehälters fest verbunden ist, und welches das erste Bauelement indirekt über einen weiteren Stab oder direkt an dem Ende des ersten Bauelements kontaktiert, das nicht mit dem zweiten Bauelement verbunden ist.

Eine besonders bevorzugte Ausführungsform der erfindungsgemäßen Kryostatanordnung sieht vor, dass das Ende des ersten Bauelements des Aktuators, das mit dem mechanischen Übersetzungselement direkt oder indirekt in Kontakt steht, eine definierte relative Bewegung in Bezug zum Übersetzungselement erfährt, so dass das Übersetzungselement diese relative Bewegung derart auf das Zentrierelement übersetzt, dass dessen mechanischer Spannungszustand annähernd unabhängig von den gerade herrschenden Temperaturen innerhalb der Kryostatanordnung ist. Die Zentrierelemente werden somit stets auf einen nahezu konstanten Druck oder Zug, vorzugsweise im Bereich ± 10% des bei Raumtemperatur herrschenden Drucks oder Zugs, belastet.

Bei einer alternativen Ausführungsform umfasst der Aktuator ein Rohr oder einen Stab mit einem beliebigen, insbesondere variablen Querschnitt, dessen thermischer Ausdehnungskoeffizient kleiner oder größer als der des zu zentrierenden Kryobehälters ist, und ein mechanisches Übersetzungselement, insbesondere einen Hebel, ein Zahnrad oder einen Exzenter. Durch den vom Kryobehälter verschiedenen thermischen Ausdehnungskoeffizient wird ein thermisches Verhalten des Rohrs oder Stabs bewirkt, welches sich von dem des Kryobehälters unterscheidet und der Bewegung des Kryobehälters bei einer Temperaturänderung entgegenwirken kann.

Vorzugsweise ist das mechanische Übersetzungselement des Aktuators mit dem zu zentrierenden Kryobehälter an einem Kontaktpunkt in der Nähe des äußeren Randes des Kryobehälters fest verbunden.

Um ein optimales Zusammenwirken der thermischen Effekte des Kryobehälters und des Rohrs oder des Stabs des Aktuators zu gewährleisten, ist das Rohr oder der Stab des Aktuators an einem Ende mit dem zu zentrierenden Kryobehälter über eine Verbindungsstelle an einem Kontaktpunkt in der Nähe der Achse des Kryobehälters fest verbunden. In Kombination mit dem mechanischen Übersetzungselement werden die thermischen Effekte des Kryobehälters vom Aktuator ausgeglichen, so dass das Zentrierelement stets nahezu gleichmäßig auf Druck oder Zug belastet ist.

Eine vorteilhafte Ausführungsform sieht vor, dass das Rohr oder der Stab des Aktuators über eine axiale Schraubverbindung an dem einen Ende, welches am Kontaktpunkt mit dem Kryobehälter verbunden ist, axial verschoben werden kann und über eine fest mit dem Kryobehälter verbundene Führungsvorrichtung in der Nähe seines anderen, der Schraubverbindung entgegen gesetzten Endes in Richtung der Rohrachse geführt wird. Das Rohr oder der Stab des Aktuators sowie das Zentrierelement können so unter Vorspannung gesetzt werden, ohne dass das Rohr oder der Stab des Aktuators seitlich ausweicht bzw. sich durchbiegt.

Im optimalen Fall erfährt das andere Ende des Rohrs oder des Stabes im Aktuator, das mit dem mechanische Übersetzungselement direkt oder indirekt über einen weiteren Stab in Kontakt steht, eine definierte relative Bewegung in Bezug zum Übersetzungselement, so dass das Übersetzungselement diese relative Bewegung derart auf das Zentrierelement übersetzt, dass dessen mechanischer Spannungszustand annähernd unabhängig von den gerade herrschenden Temperaturen innerhalb der Kryostatanordnung ist.

Die erfindungsgemäße Anordnung kann besonders vorteilhaft eingesetzt werden, wenn einer der Kryobehälter mit kryogenem Fluid eine supraleitende Magnetanordnung enthält.

Ein besonders bevorzugter Einsatz der Erfindung ergibt sich, wenn die supraleitende Magnetanordnung Teil einer Apparatur zur Kernspinresonanz, insbesondere Magnetic Resonance Imaging (MRI) oder Magnetresonanzspektroskopie (NMR) ist.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:

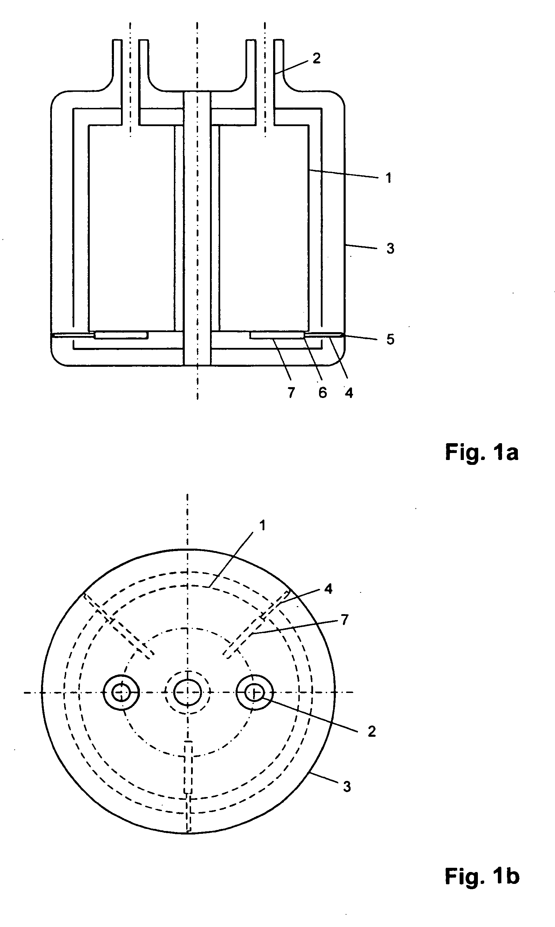

Fig. 1a     eine schematische Seitenansicht einer erfindungsgemäßen Kryostatanordnung zur Aufbewahrung eines kryogenen Fluids mit Zentrierelementen;

Fig. 1 b     eine schematische Aufsicht einer erfindungsgemäßen Kryostatanordnung zur Aufbewahrung eines kryogenen Fluids mit Zentrierelementen;

Fig. 2a     eine schematische Seitenansicht einer erfindungsgemäßen Kryostatanordnung mit Zentrierelementen und einer asymmetrischen Öffnung zur Aufbewahrung eines flüssigen Kryogens;

Fig. 2b     eine schematische Aufsicht einer erfindungsgemäßen Kryostatanordnung mit Zentrierelementen und einer asymmetrischen Öffnung zur Aufbewahrung eines flüssigen Kryogens;

Fig. 3a     einen schematischen Ausschnitt einer Ausführungsform der erfindungsgemäßen Kryostatanordnung mit einem Aktuator und einem auf Druck beanspruchten Zentrierelement;

Fig. 3b     einen schematischen Ausschnitt einer Ausführungsform der erfindungsgemäßen Kryostatanordnung mit einem Aktuator und einem auf Zug beanspruchten Zentrierelement;

Fig. 4a     einen schematischen Ausschnitt einer Ausführungsform der erfindungsgemäßen Kryostatanordnung mit einem am oberen Rand eines zu zentrierenden Kryobehälters montierten Aktuator;

Fig. 4b     einen schematischen Ausschnitt einer Ausführungsform der erfindungsgemäßen Kryostatanordnung mit einem am oberen Rand eines zu zentrierenden Kryobehälters montierten Aktuator und einem thermischen Verbindungselement zwischen Zentrierelement und Strahlungsschild;

Fig. 4c     einen schematischen Ausschnitt einer Ausführungsform der erfindungsgemäßen Kryostatanordnung mit einem am unteren Rand eines zu zentrierenden Kryobehälters montierten Aktuator und einem Zentrierelement, wobei einzelne Längen zur Berechnung des Aktuators und Zentrierelements definiert werden;

Fig. 5a     einen schematischen Ausschnitt einer Ausführungsform der erfindungsgemäßen Kryostatanordnung mit einem mechanischen Übersetzungselement;

Fig. 5b     einen schematischen Ausschnitt einer Ausführungsform der erfindungs-gemäßen Kryostatanordnung mit einem mechanischen Übersetzungselement, wobei der Stab im Aktuator auf Druck belastet wird; und

Fig. 5c     einen schematischen Ausschnitt einer Ausführungsform der erfindungs-gemäßen Kryostatanordnung mit einem mechanischen Übersetzungselement, wobei der Stab im Aktuator auf Zug belastet wird.

**Fig. 1a** und **Fig. 1b** zeigen Ausführungsformen der erfindungsgemäßen Kryostatanordnung mit einem Kryobehälter **1** zur Aufbewahrung einer kryogenen Flüssigkeit, der mit Aufhängerohren **2** an einem Außenmantel **3** der Kryostatanordnung befestigt ist. Um den Kryobehälter 1 gegen den Außenmantel 3 der Kryostatanordnung zu zentrieren, befinden sich am unteren Ende des Kryobehälters 1 Zentriervorrichtungen, die mit dem Kryobehälter 1 verbunden sind und den Außenmantel 3 über Zentrierelemente **4** kontaktieren. Die Zentrierelemente 4 liegen mit ihren einen Enden 5 am Außenmantel 3 an oder sind daran befestigt. Mit dem anderen Ende 6 sind die Zentrierelemente mit einem Aktuator 7 verbunden, der auf das Zentrierelement 4 eine Druck- oder Zugkraft ausübt.

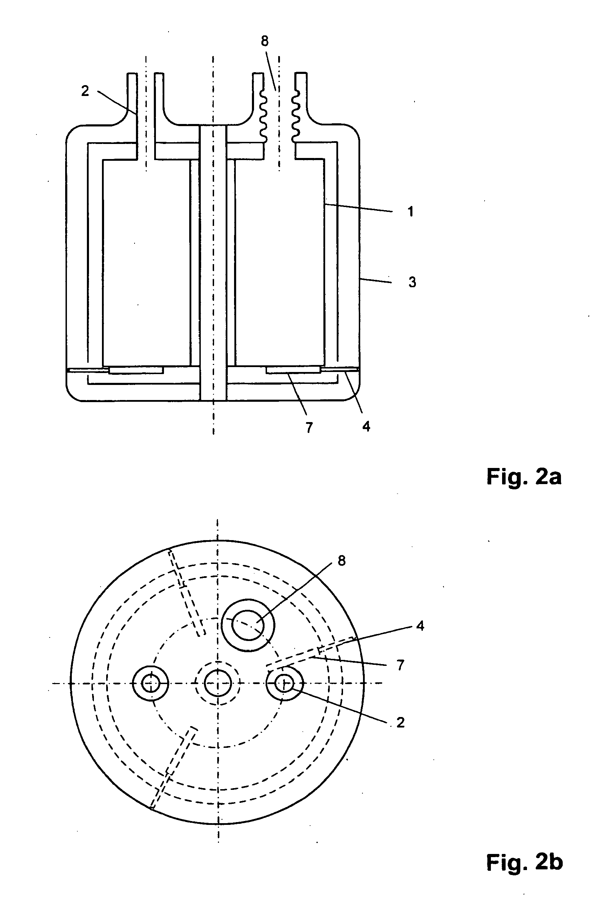

**Fig. 2a** und **Fig. 2b** zeigen Ausführungsformen der erfindungsgemäßen Kryostatanordnung, bei denen der Kryobehälter 1 ein als asymmetrische Öffnung **8** ausgebildetes Halsrohr umfasst. Diese asymmetrische Anordnung der Öffnung 8 ist insbesondere aus Fig. 2b ersichtlich.

Vorzugsweise sind jeweils drei Zentrierelemente 4 gleichmäßig über den Umfang des Kryobehälters 1 verteilt, wie in den Aufsichten der Figuren 1b und 2b dargestellt. Der Übersichtlichkeit halber wurden die Zentrierelemente 4 in den Seitenansichten der Fig. 1 a und Fig. 2a jedoch gegenüberliegend dargestellt. Der Aktuator 7 kann am unteren oder am oberen Behälterdeckel angebracht werden. Zusätzlich können dann am anderen Behälterdeckel weitere Abstandshalter, z.B. Zentrier-elemente mit Aktuator oder konventionelle Zugzentrierungen, verwendet werden.

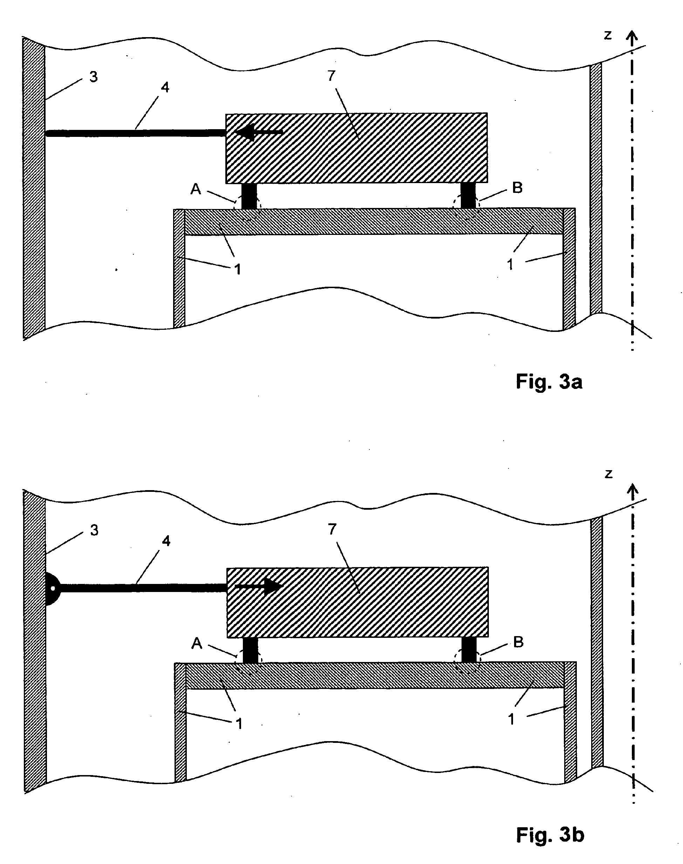

**Fig. 3a** zeigt einen schematischen Ausschnitt einer Ausführungsform der erfindungsgemäßen Kryostatanordnung, bei der das Zentrierelement 4 auf Druck beansprucht wird. Das Zentrierelement 4 ist fest mit dem Aktuator 7 verbunden und kontaktiert den Außenmantel 3. Der Aktuator 7 ist an einem Kontaktpunkt A, vorzugsweise in der Nähe des äußeren Randes des Kryobehälters 1 und an einem Kontaktpunkt B, vorzugsweise in der Nähe der Achse z des Kryobehälters 1 mit diesem fest verbunden.

Bei der in **Fig. 3b** gezeigten Ausführungsform wird das Zentrierelement 4 auf Zug beansprucht. Hier besteht eine feste Verbindung sowohl zwischen dem Zentrierelement 4 und dem Aktuator 7 als auch zwischen dem Zentrierelement 4 und dem Außenmantel 3.

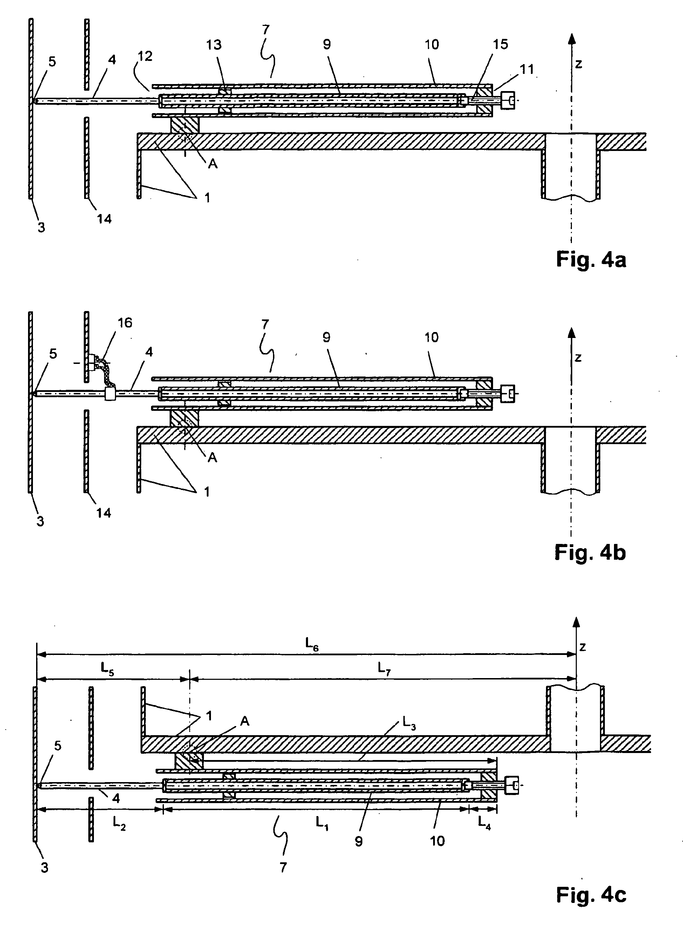

**Fig. 4a** zeigt einen detaillierten Ausschnitt der erfindungsgemäßen Kryostatanordnung. Der Aktuator 7 ist, beispielsweise mittels Verschraubungen, am Kontaktpunkt A mit dem zu zentrierenden Kryobehälter, 1 verbunden und umfasst im Wesentlichen zwei Bauelemente **9, 10.**

Es gibt ein erstes, zentrales Bauelement 9, das aus einem Material mit kleinem positiven (wie zum Beispiel ein kohlefaserverstärkter Kunststoff) oder sogar negativem thermischen Ausdehnungskoeffizienten gefertigt ist. Es ist vorzugsweise als Rohr ausgebildet. Bei Abkühlung wird es nur unwesentlich kürzer oder sogar ein wenig länger.

Das zweite Bauelement 10 ist ein Rohr, welches ein geschlossenes Ende 11 und ein offenes Ende 12 aufweist. Es besitzt einen größeren Durchmesser als das erste Bauelement 9 und das Zentrierelement 4. Ebenso ist es auch möglich, als zweites Bauelement 10 einen Kanal mit rechteckigem Querschnitt vorzusehen. Das zweite Bauelement 10 besteht aus einem Material mit großem positiven thermischen Ausdehnungskoeffizienten (wie zum Beispiel Aluminium), so dass es sich bei Abkühlung stark verkürzt.

Um das erste Bauelement 9 des Aktuators 7 ist eine Führungshülse **13** angebracht, wobei zwischen der Führungshülse 13 und dem zweiten Bauelement 10 ein Spiel bestehen bleibt, so dass eine Verschiebung des ersten Bauelements 9 gegenüber dem zweiten Bauelement 10 in Richtung der Achse des Zentrierelements 4 ohne Durchbiegung des Bauelements 9 ermöglicht wird. Bei einer Biegebeanspruchung der Anordnung resultiert somit auch keine unzulässig hohe Spannung an der Verbindungsstelle zwischen dem ersten Bauelement 9.und dem zweiten Bauelement 10.

Das Zentrierelement 4 ist als Stab ausgebildet, der einen Strahlungsschild **14** durchdringt. Es besteht aus einem Material schlechter Wärmeleitfähigkeit, weist eine hohe mechanische Festigkeit auf und besitzt höchstens einen mäßigen positiven thermischen Ausdehnungskoeffizienten (wie zum-Beispiel glasfaserverstärkter Kunststoff). Der Stab des Zentrierelements 4 wird einerseits relativ dünn gewählt, damit er auch die vertikale Verschiebung des Kryobehälters 1 zum Außenmantels 3, ,an denen sich die Anlenkpunkte der Zentrierelemente 4 befinden, während und nach dem Abkühlen aufnehmen kann, wobei er sich dabei durchbiegt. Da das Zentrierelement 4 andererseits zusätzlich zur Biegebeanspruchung auf Druck belastet wird - wie auch die Bauelemente 9, 10 des Aktuators 7 - muss es auch so dimensioniert werden, dass es unter der Druckbelastung dann nicht abknickt.

Das erste Bauelement 9 ist mit dem Zentrierelement 4 fest verbunden, zum Beispiel in einer Hülse aus Aluminium verklebt. Die somit verbundenen Elemente 4, 9 werden im Bereich des ersten Bauelements 9 in das zweiten Bauelement 10, welches als Rohr ausgebildet ist, geschoben und dort an dessen geschlossenem Ende 11 beispielsweise mittels einer Schraubverbindung **15** fest miteinander verbunden. Das zweite Bauelement 10 ist am oder in der Nähe des offenen Rohrendes 12 fest mit dem Kryobehälter 1, den das Zentrierelement 4 abstützen soll, verschraubt, und zwar am Kontraktpunkt A in der Nähe des äußeren Kryobehälterrands. Das freie Ende 5 des Zentrierelements 4 drückt auf die Wand des Außenmantels 3 der Kryostatanordnung. Das Zentrierelement 4 und der Aktuator 7 werden am Kryobehälter 1 unter Vorspannung montiert. Zu diesem Zwecke sind das Zentrierelement 4 und das erste Bauelement 9, welche miteinander verbunden sind, über die Schraubverbindung 15 an der Verbindungsstelle mit dem zweiten Bauelement 10 in horizontaler Richtung verschiebbar.

**Fig. 4b** zeigt einen schematischen Ausschnitt einer Ausführungsform der erfindungsgemäßen Kryostatanordnung mit einem thermischen Verbindungselement **16,** welches das Zentrierelement 4 und den Strahlungsschild 14 verbindet. Durch das thermische Verbindungselement 16 wird der Wärmeeintrag vom Außenmantel 3 zumindest teilweise vom Strahlungsschild 14 abgefangen und somit der Wärmeeintrag auf den Kryobehälter 1 reduziert.

Die Längen und die thermischen Ausdehnungskoeffizienten der einzelnen Elemente 4, 9, 10 einer auf Druck belasteten Zentriervorrichtung, werden so gewählt und angepasst, dass die folgenden Bedingungen erfüllt sind:

- Auch nach der Abkühlung muss das Zentrierelement 4 noch auf Druck belastet sein. Die Längenabnahme des zweiten Bauelements 10 führt dazu, dass das freie Ende 5 des Zentrierelements 4 selbst bei einer geringen Verkürzung des Zentrierelements 4 immer noch auf Druck belastet. Ist die Geometrie der Bestandteile 4, 9, 10 nicht genau aufeinander abgestimmt, kann es vorkommen, dass das Zentrierelement 4 die Wand nach der Abkühlung nicht mehr berührt oder so stark gestaucht wird, dass es knickt, der Spannungszustand in diesem Fall also nicht, wie angestrebt, annähernd konstant bleibt.

- Der Wärmeeintrag durch Wärmeleitung über die Zentriervorrichtung soll so gering wie möglich sein. Daher sollte speziell das Zentrierelement 4 möglichst lang und dünn gewählt werden.

- Das Zentrierelement 4 muss ferner die Verschiebung des Kryobehälters 1 in vertikaler Richtung, die bei der Abkühlung auftritt, aufnehmen können ohne zu brechen. Da es auch an seinem freien Ende 5 durch die Vorspannung und Anpresskraft, verstärkt im Fall einer asymmetrischen Geometrie auf Grund der Druckdifferenz Umgebung/ Vakuum, an die äußere Wand gepresst wird - also dort fixiert ist -, wird es sich während der Abkühlung mehr oder weniger stark durchbiegen.

Anhand des in **Fig. 4c** abgebildeten Ausführungsbeispiels wird eine optimale geometrische Gestaltung des Zentrierelements 4 und der Bauelemente 9, 10 des Aktuators 7 qualitativ und vereinfacht beschrieben, um die erwähnten Zusammen-hänge zu illustrieren. Im optimalen Fall stützt sich die Spitze des Druckstabes (also das freie Ende 5 des Zentrierelementes 4) vor und nach dem Abkühlen unter Beibehaltung des Spannungszustands auf die Wand des Außenmantels 3 ab.

Allgemein gilt für die Längenänderung $\Delta L_i$ eines Elements der ursprünglichen Länge $L_{i,0}$ bei einer Temperaturänderung $\Delta T$:

$$\Delta L_i = \alpha_i \cdot L_{i,0} \cdot \Delta T \,,$$

wobei $\alpha_i$ der thermische Ausdehnungskoeffizient ist, dessen Größe von der Temperatur abhängt. Er ist für die meisten Werkstoffe positiv, so dass bei Temperaturabnahme eine Schrumpfung des Bauteils zu beobachten ist ($\Delta L_i < 0$).

Die Länge im kalten Zustand berechnet sich somit aus der Länge im warmen Zustand zu:

$$L_i = \left(1 + \alpha_i \Delta T\right)L_{i,0}$$

Die Teillängen $L_2$, $L_1$ und $L_4$ müssen im Idealfall auch nach der Abkühlung mindestens so groß wie die Summe der Teillängen $L_3$ und $L_5$ sein.

$$L_2 + L_1 + L_4 \geq L_3 + L_5$$

Die Länge $L_5$ ($\cong$ Abstand zwischen Behältern 1, 3) ergibt sich aus der Schrumpfung des Behälters 1 zu:

$$L_5 = L_6 - L_7$$

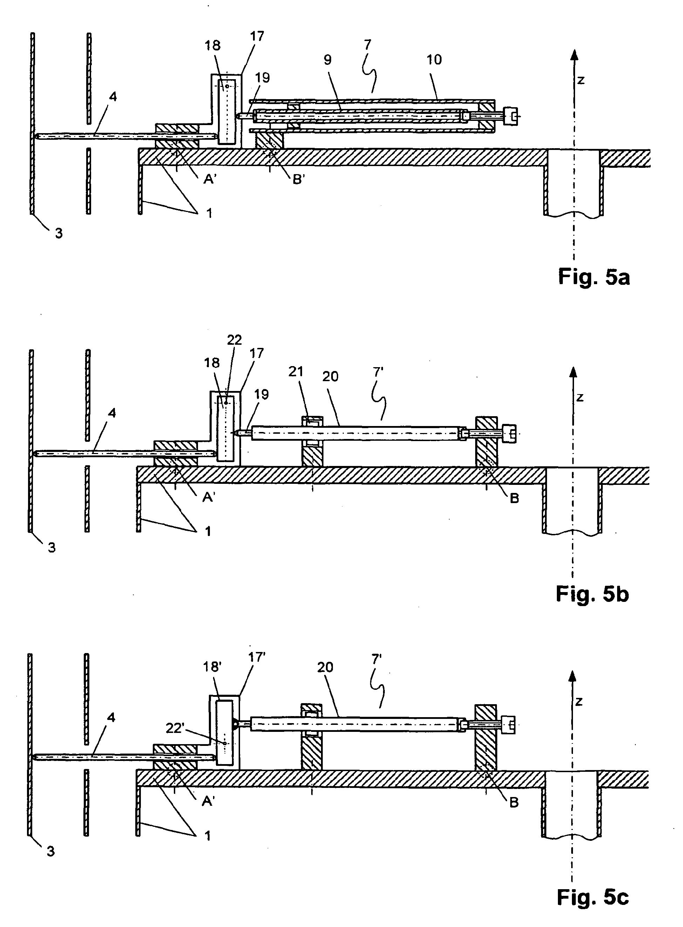

**Fig. 5a** zeigt eine Ausführungsform, bei der zusätzlich zu dem in den Fig. 4a - 4c beschriebenen Elemente 9, 10 des Aktuators 7 ein Übersetzungselement **17** in Form eines Hebels **18** vorgesehen ist. Der Druckausgleich gegen den Außenmantel 3 wird bei dieser Ausführungsform sowohl über die thermische Längenänderungen der Bauelemente 4, 9, 10 als auch über einen Hebelmechanismus bewirkt. Das Übersetzungselement 17 ist an einem Kontaktpunkt **A'** in der Nähe des äußeren Rands des Kryobehälters 1 mit diesem verbunden. Ein Kontaktpunkt B' des Aktuators 7 mit dem Kryobehälter 1 befindet sich bezüglich des Kontaktpunktes A' des Übersetzungselements 17 näher an der Achse z des Kryobehälters 1, jedoch immer noch in der Nähe des äußeren Randes des Kryobehälters 1. Das freie Ende eines am ersten Bauelement 9 angebrachten weiteren Stabes 19 ist mit dem kurzen Arm des Hebels 18 verbunden. Im Gegensatz zu den zuvor beschriebenen Ausführungsformen ist das Zentrierelement 4, das bis an die Wand des Außenmantels 3 reicht, nicht am ersten Bauelement 9 befestigt, sondern kontaktiert den langen Hebelarm des Übersetzungselements 17. Wird der Kryobehälter 1 nun abgekühlt zieht er sich zusammen und die Kontaktpunkte A', B' verschieben sich, da sie sehr nahe beieinander liegen, in etwa gleich weit in Richtung der Kryobehälterachse z. Durch die oben beschriebene geeignete Wahl der Materialen für die einzelnen Elemente 4, 9, 10 kann diese Verschiebung vollständig ausgeglichen werden. Ist der Ausgleich aber nicht genügend, kann die Bewegung des ersten Bauelements 9 dabei durch den Hebel 18 in eine größere Auslenkung des Zentrierelements 4 umgesetzt werden, so dass das Zentrierelement 4 ständig auf nahezu konstantem Druck belastet wird. Somit können Positionsänderungen des Kryobehälters 1 aufgrund von Temperaturschwankungen ausgeglichen werden.

Fig. 5b zeigt einen Ausschnitt einer Ausführungsform der erfindungsgemäßen Kryostatanordnung mit einem einen Stab 20 umfassenden Aktuator 7'. Der Stab 20 wird bei dieser Ausführungsform auf Druck belastet und besteht aus einem Material mit negativem oder kleinem positiven thermischen Ausdehnungskoeffizienten. Im Gegensatz zu den in den Fig. 4a-c und Fig. 5a gezeigten Ausführungsformen ist der Aktuator 7' über eine Verbindungsstelle an einem Kontaktpunkt B nahe an der Kryobehälterachse z mit dem zu zentrierenden Kryobehälter 1 verbunden. Eine Führungsvorrichtung 21 sorgt für eine stabile Lage des Stabes 20. Der Stab 20 des Aktuators 7' drückt an dem dem Kontaktpunkt B entgegengesetzten Ende des Aktuators 7' indirekt über den weiteren Stab 19 auf den Hebel 18 des Übersetzungselements 17. Da Kryobehälter im Allgemeinen aus einem Material mit positivem thermischen Ausdehnungskoeffizienten bestehen, zieht sich der Kryobehälter 1, wenn er abgekühlt wird, am äußeren Rand viel mehr zusammen als innen in der Nähe der Achse z. Somit verschiebt sich auch der Kontaktpunkt A' des Übersetzungselements 17 und somit der Drehpunkt **22** des Hebels 18 nach rechts in Richtung der Kryobehälterachse z, während der Kontaktpunkt B, an dem der Stab 20 mit dem Kryobehälter 1 verbunden ist, sich nur wenig in Richtung der Kryobehälterachse z bewegt. Insgesamt bewegen sich also die Kontaktpunkte aufeinander zu. Der Stab 20 bleibt in etwa gleich lang und lenkt den Hebel 18 des Übersetzungselements 17 so aus, dass das Zentrierelement 4 immer auf etwa den gleichen Druck beansprucht wird. Der Abstand der Kontaktpunkte A' und B muss so gewählt werden, dass der Hebel 18 sowohl die Längenänderung des Zentrierelements 4, des Stabs 20 des Aktuators 7' als auch die (kleine) Verschiebung des achsennahen Kontaktpunktes B ausgleicht.

Fig. 5c zeigt eine weitere Ausführungsform, bei der der Stab 20 des Aktuators 7' auf Zug belastet wird. In diesem Fall ist der Stab 20 des Aktuators 7' aus einem Material mit positiven thermischen Ausdehnungskoeffizienten größer als der des Kryobehälters 1 gefertigt und oberhalb des Drehpunktes 22' des Hebels 18' befestigt, wohingegen das Zentrierelement 4 unterhab des Drehpunktes 22' den Hebel 18' des Übersetzungselements 17' kontaktiert. Der Stab 20 des Aktuators 7' zieht sich bei einer Abkühlung stärker zusammen als der Kryobehälter, so dass der Stab 20 des Aktuators 7' am Hebel 18' des Übersetzungselements 17' zieht und der Hebel 18' unterhalb des Drehpunktes 22' in Richtung Zentrierelement 4 ausgelenkt wird. Das Zentrierelement 4 ist bei geeigneter Wahl von Materialien und Geometrie somit weiter annähernd gleichmäßig auf Druck belastet.

Insgesamt ergibt sich eine Kryostatanordnung mit Druck- oder Zugzentrierung, bei der ein oder mehrere Behälter unabhängig von der herrschenden Temperatur gegeneinander zentriert werden können und der Spannungszustand im Zentrierelement annähernd konstant bleibt.

**Bezugszeichenliste**

1 Kryobehälter
2 Aufhängerohr
3 Außenmantel
4 Zentrierelement
5 freies Ende des Zentrierelements
6 anderes Ende des Zentrierelements
7 Aktuator
7' Aktuator
8 asymmetrische Öffnung
9 erstes Bauelement des Aktuators
10 zweites Bauelement des Aktuators
11 geschlossenes Ende des zweiten Bauelements
12 offenes Ende des zweiten Bauelements
13 Führungshülse
14 Strahlungsschild
15 axiale Schraubverbindung
16 thermisches Verbindungselement
17 Übersetzungselement
17' Übersetzungselement
18 Hebel
18' Hebel
19 weiterer Stab
20 Stab oder Rohr
21 Führungsvorrichtung
22 Drehpunkt des Hebels
22' Drehpunkt des Hebels

A Kontaktpunkt des Aktuators mit dem Kryobehälter in der Nähe des äußeren Randes des Kryobehälters
A' Kontaktpunkt des Übersetzungselements mit dem Kryobehälter in der Nähe des äußeren Randes des Kryobehälters
B Kontaktpunkt des Aktuators mit dem Kryobehälter in der Nähe der Achse z
B' Kontaktpunkt des Aktuators mit dem Kryobehälter in der Nähe des Überset-zungselements
z Achse des Kryobehälters

**Patentansprüche**

1. Kryostatanordnung zur Aufbewahrung von kryogenen Fluiden in mindestens einem Kryobehälter (1), welcher an thermisch isolierenden Aufhängerohren (2) und/oder Aufhängevorrichtungen aufgehängt ist, die mit einem Außenmantel (3) der Kryostatanordnung verbunden sind, wobei der mindestens eine Kryobehälter (1) mit Hilfe von mindestens drei über den Umfang des Kryobehälters (1) verteilten Zentrierelementen (4) gegen einen weiter außen liegenden Behälter, vorzugsweise gegen den Außenmantel (3), zentriert wird, wobei die Zentrierelemente (4) mit jeweils einem Ende (5) am weiter außen liegenden Behälter anliegen oder befestigt sind, **dadurch gekennzeichnet, dass** bei mindestens einem der Kryobehälter (1) die Zentrierelemente (4) an ihren dem Außenmantel (3) abgewandten Enden (6) jeweils mit einem Aktuator (7) verbunden sind, der auf das jeweilige Zentrierelement (4) eine Druck- oder Zugkraft ausübt, und der mindestens an einem Kontaktpunkt (A, A', B, B') an dem Kryobehälter (1) montiert ist, wobei die Wärmeausdehnungskoeffizienten und die Abmaße der Elemente des Aktuators (7) so gewählt sind, dass durch die Fixierung des Aktuators (7) am Kontaktpunkt (A, A', B, B') am Kryobehälter (1) sowie durch thermisch bedingte Veränderungen der Abmaße des Kryobehälters (1) und thermisch bedingte Veränderungen der Abmaße einzelner Bauelemente des Aktuators (7) und gegebenenfalls durch eine mechanische Übersetzung eine mechanische Spannung in den entsprechenden Zentrierelementen (4) erzeugt wird, so dass die Zentrierelemente (4) unabhängig von den Temperaturen innerhalb der Kryostatanordnung stets auf einem nahezu konstanten Druck oder Zug, vorzugsweise im Bereich $\pm 10\%$ des bei Raumtemperatur herrschenden Drucks oder Zugs, belastet werden.

2. Kryostatanordnung nach Anspruch 1, **dadurch gekennzeichnet, dass** der Kryobehälter (1) eine zusätzliche, asymmetrische Öffnung (8) nach außen aufweist.

3. Kryostatanordnung nach einem der vorhergehenden Ansprüche, **dadurch gekennzeichnet, dass** zumindest eines der Zentrierelemente (4) über ein die Wärme gut leitendes und flexibles Verbindungselement (16) mit einem weiteren Kryobehälter oder einem Strahlungsschild (14), der sich zwischen dem zu zentrierenden Kryobehälter (1) und dem weiter außen liegenden Behälter befindet; thermisch kontaktiert ist.

4. Kryostatanordnung nach einem der vorhergehenden Ansprüche, **dadurch gekennzeichnet, dass** die Zentrierelemente (4) aus glasfaserverstärktem Kunststoff oder einem Material ähnlicher thermischer und mechanischer Eigenschaften gefertigt sind.

5. Kryostatanordnung nach einem der vorhergehenden Ansprüche, **dadurch gekennzeichnet, dass** die Zentrierelemente (4) jeweils als Rohr oder Stab mit einem beliebigen, insbesondere variablen, Querschnitt ausgebildet sind.

6. Kryostatanordnung nach einem der vorhergehenden Ansprüche, **dadurch gekennzeichnet, dass** der Aktuator (7) ein erstes (9) und ein zweites Bauelement (10) umfasst, wobei die Bauelemente (9, 10) aus Materialien von unterschiedlichen thermischen Ausdehnungskoeffizienten gefertigt sind.

7. Kryostatanordnung nach Anspruch 6, **dadurch ge-**

**kennzeichnet, dass** das erste Bauelement (9) des Aktuators (7) aus einem Material mit einem thermischen Ausdehnungskoeffizienten gefertigt ist, der kleiner oder gleich 0 ist.

8. Kryostatanordnung nach Anspruch 6, **dadurch gekennzeichnet, dass** das erste Bauelement (9) des Aktuators (7) aus einem Material mit einem positiven thermischen Ausdehnungskoeffizienten gefertigt ist, dessen Betrag so gewählt ist, dass bei einer Temperaturänderung die absolute Längenänderung des ersten Bauelements (9) weniger als die absolute Längenänderung des zweiten Bauelements (10), vorzugsweise höchstens ein Fünftel der absoluten Längenänderung des zweiten Bauelements (10), beträgt.

9. Kryostatanordnung nach einem der Ansprüche 6 bis 8, **dadurch gekennzeichnet, dass** das erste Bauelement (9) des Aktuators (7) als Rohr oder Stab mit einem beliebigen, insbesondere variablen, Querschnitt ausgebildet ist.

10. Kryostatanordnung nach einem der Ansprüche 6 bis 9, **dadurch gekennzeichnet, dass** das zweite Bauelement (10) des Aktuators (7) aus einem Material mit einem großen positiven thermischen Ausdehnungskoeffizienten gefertigt ist, insbesondere aus Kupfer, Messing, Aluminium oder einem Material ähnlicher thermischer und mechanischer Eigenschaften.

11. Kryostatanordnung nach einem der Ansprüche 6 bis 10, **dadurch gekennzeichnet, dass** das zweite Bauelement (10) des Aktuators (7) als einseitig geschlossenes Rohr oder einseitig geschlossener Kanal ausgebildet ist.

12. Kryostatanordnung nach einem der Ansprüche 6 bis 11, **dadurch gekennzeichnet, dass** das erste Bauelement (9) des Aktuators (7) innerhalb des als Rohr oder Kanal ausgebildeten zweiten Bauelements (10) des Aktuators (7), insbesondere koaxial, angeordnet ist.

13. Kryostatanordnung nach einem der Ansprüche 11 oder 12, **dadurch gekennzeichnet, dass** das erste Bauelement (9) des Aktuators (7) mit dem als Rohr oder Kanal ausgebildeten zweiten Bauelement (10) des Aktuators (7) am geschlossenen Rohrende (11) des zweiten Bauelements (10) über eine axiale Schraubverbindung (15) verschiebbar verbunden ist, derartig, dass das erste Bauelement (9) in Bezug auf das zweite Bauelement (10) in Richtung der Rohrachse verschoben werden kann.

14. Kryostatanordnung einem der Ansprüche 6 bis 13, **dadurch gekennzeichnet, dass** um das erste Bauelement (9) des Aktuators (7) eine Führungshülse (13) angebracht ist, welche fest auf dem ersten Bauelement (9) sitzt und deren Außendurchmesser so groß ist, dass zwischen der Führungshülse (13) und dem zweiten Bauelement (10) ein Spiel bestehen bleibt.

15. Kryostatanordnung nach einem der Ansprüche 11 bis 14 **dadurch gekennzeichnet, dass** das als Rohr oder Kanal ausgebildete zweite Bauelement (10) des Aktuators (7) am oder in der Nähe seines offenen Rohrendes (12) mit dem gegenüber dem weiter außen liegenden Behälter zu zentrierenden Kryobehälter (1) an einem Kontaktpunkt (A), vorzugsweise in der Nähe des äußeren Randes des Kryobehälters (1), fest verbunden ist.

16. Kryostatanordnung nach einem der Ansprüche 6 bis 15, **dadurch gekennzeichnet, dass** das erste Bauelement (9) des Aktuators (7) an einem Ende, welches nicht mit dem zweiten Bauelement (10) verbunden ist, mit dem Zentrierelement (4) fest verbunden ist.

17. Kryostatanordnung nach einem der Ansprüche 6 bis 15, **dadurch gekennzeichnet, dass** der Aktuator (7) zusätzlich ein mechanisches Übersetzungselement (17) umfasst, insbesondere einen Hebel (18), ein Zahnrad oder einen Exzenter, welches mit dem zu zentrierenden Kryobehälter (1) an einem Kontaktpunkt (A') in der Nähe des äußeren Randes des Kryobehälters (1) fest verbunden ist, und welches das erste Bauelement (9) indirekt über einen weiteren Stab (19) oder direkt an dem Ende des ersten Bauelements (9) kontaktiert, das nicht mit dem zweiten Bauelement (10) verbunden ist.

18. Kryostatanordnung nach Anspruch 17, **dadurch gekennzeichnet, dass** das Ende des ersten Bauelements (9) des Aktuators (7), das mit dem mechanischen Übersetzungselement (17) direkt oder indirekt in Kontakt steht, eine definierte relative Bewegung in Bezug zum Übersetzungselement (17) erfährt, so dass das Übersetzungselement (17) diese relative Bewegung derart auf das Zentrierelement (4) übersetzt, dass dessen mechanischer Spannungszustand annähernd unabhängig von den gerade herrschenden Temperaturen innerhalb der Kryostatenanordnung ist.

19. Kryostatanordnung nach einem der Ansprüche 1 bis 5, **dadurch gekennzeichnet, dass** der Aktuator (7') ein Rohr oder einen Stab (20) mit einem beliebigen, insbesondere variablen Querschnitt, dessen thermischer Ausdehnungskoeffizient kleiner oder größer als der des zu zentrierenden Kryobehälters (1) ist, und ein mechanisches Übersetzungselement (17, 17'), insbesondere einen Hebel (18, 18'), ein Zahnrad oder einen Exzenter, umfasst.

**20.** Kryostatanordnung nach Anspruch 19, **dadurch gekennzeichnet, dass** das mechanische Übersetzungselement (17, 17') des Aktuators (7') mit dem zu zentrierenden Kryobehälter (1) an einem Kontaktpunkt (A') in der Nähe des äußeren Randes des Kryobehälters (1) fest verbunden ist.

**21.** Kryostatanordnung nach einem der Ansprüche 19 bis 20, **dadurch gekennzeichnet, dass** das Rohr oder der Stab (20) des Aktuators (7') an einem Ende mit dem zu zentrierenden Kryobehälter (1) an einem Kontaktpunkt (B) in der Nähe der Achse (z) des Kryobehälters (1) fest verbunden ist.

**22.** Kryostatanordnung nach Anspruch 21, **dadurch gekennzeichnet, dass** das Rohr oder der Stab (20) des Aktuators (7') an dem einen Ende, welches am Kontaktpunkt (B) mit dem Kryobehälter (1) verbunden ist, über eine axiale Schraubverbindung (15) axial verschoben werden kann und über eine fest mit dem Kryobehälter (1) verbundene Führungsvorrichtung (21) in der Nähe seines anderen, der Schraubverbindung (15) entgegengesetzten Endes in Richtung der Rohrachse geführt wird.

**23.** Kryostatanordnung nach einem der Ansprüche 19 bis 22, **dadurch gekennzeichnet, dass** das andere Ende des Rohrs oder des Stabes (20) im Aktuator (7'), das mit dem mechanische Übersetzungselement (17, 17') direkt oder indirekt über einen weiteren Stab (19) in Kontakt steht, eine definierte relative Bewegung in Bezug zum Übersetzungselement (17, 17') erfährt, so dass das Übersetzungselement (17, 17') diese relative Bewegung derart auf das Zentrierelement (4) übersetzt, dass dessen mechanischer Spannungszustand annähernd unabhängig von den gerade herrschenden Temperaturen innerhalb der Kryostatanordnung ist.

**24.** Kryostatanordnung nach einem der vorhergehenden Ansprüche, **dadurch gekennzeichnet, dass** einer der Kryobehälter (1) mit kryogenem Fluid eine supraleitende Magnetanordnung enthält.

**25.** Kryostatanordnung nach Anspruch 24, **dadurch gekennzeichnet, dass** die supraleitende Magnetanordnung Teil einer Apparatur zur Kernspinresonanz, insbesondere Magnetic Resonance Imaging (MRI) oder Magnetresonanzspektroskopie (NMR) ist.

**Claims**

**1.** Cryostat configuration for keeping cryogenic fluids in at least one cryocontainer (1) which is suspended on thermally insulating suspension tubes (2) and/or suspension devices which are connected to an outer jacket (3) of the cryostat configuration, wherein the at least one cryocontainer (1) is centered relative to a container which is disposed further outside, preferably the outer jacket (3), using at least three centering elements (4) which are distributed about the periphery of the cryocontainer (1), wherein one end (5) of each centering element (4) abuts or is connected to the container which is disposed further outside, **characterized in that** the centering elements (4) of at least one of the cryocontainers (1) are each connected at their ends (6) facing away from the outer jacket (3) to an actuator (7) which exerts a pressure or tensile force on the respective centering element (4), and which is mounted to the cryocontainer (1) at at least one contact point (A, A', B, B'), wherein the heat expansion coefficient and the size of the components of the actuator (7) are selected such that, through fixation of the actuator (7) to the cryocontainer (1) at the contact point (A, A', B, B'), due to thermal changes in size of the cryocontainer (1), due to thermal changes in size of individual components of the actuator (7), and optionally due to mechanical translation, a mechanical tension is generated in the corresponding centering elements (4) such that the centering elements (4) remain loaded at a nearly constant pressure or tension irrespective of the temperatures within the cryostat configuration, preferably in the range of $\pm 10\%$ of the pressure or tension prevailing at room temperature.

**2.** Cryostat configuration according to claim 1, **characterized in that** the cryocontainer (1) comprises an additional asymmetric outward opening (8).

**3.** Cryostat configuration according to any one of the preceding claims, **characterized in that** at least one of the centering elements (4) is in thermal contact with a further cryocontainer or radiation shield (14), which is located between the cryocontainer (1) to be centered and the container which is disposed outside, via a flexible connecting element (16) having good thermally conducting properties.

**4.** Cryostat configuration according to any one of the preceding claims, **characterized in that** the centering elements (4) are produced from fiber glass reinforced plastic material or from a material having similar thermal and mechanical properties.

**5.** Cryostat configuration according to any one of the preceding claims, **characterized in that** each centering element (4) is formed as a tube or rod of arbitrary cross-section, in particular variable cross-section.

**6.** Cryostat configuration according to any one of the preceding claims, **characterized in that** the actuator (7) comprises a first (9) and a second component (10), wherein the components (9, 10) are produced from materials having different thermal expansion coefficients.

7. Cryostat configuration according to claim 6, **characterized in that** the first component (9) of the actuator (7) is produced from a material having a thermal expansion coefficient which is smaller than or equal to zero.

8. Cryostat configuration according to claim 6, **characterized in that** the first component (9) of the actuator (7) is produced from a material having a positive thermal expansion coefficient whose value is selected such that, in response to a temperature change, the absolute length change of the first component (9) is less than the absolute length change of the second component (10), preferably at most one fifth of the absolute length change of the second component (10).

9. Cryostat configuration according to any one of the claims 6 through 8, **characterized in that** the first component (9) of the actuator (7) is designed as a tube or rod having an arbitrary cross-section, in particular variable cross-section.

10. Cryostat configuration according to any one of the claims 6 through 9, **characterized in that** the second component (10) of the actuator (7) is produced from a material having a large positive thermal expansion coefficient, in particular from copper, brass, aluminium or a material having similar thermal and mechanical properties.

11. Cryostat configuration according to any one of the claims 6 through 10, **characterized in that** the second component (10) of the actuator (7) is formed as tube which is closed at one end or channel which is closed at one end.

12. Cryostat configuration according to any one of the claims 6 through 11, **characterized in that** the first component (9) of the actuator (7) is disposed within the second component (10) of the actuator (7) which is designed as tube or channel, in particular, in a coaxial direction.

13. Cryostat configuration according to one of the claims 11 or 12, **characterized in that** the first component (9) of the actuator (7) is displaceably connected to the second component (10) of the actuator (7), designed as tube or channel, at the closed tube end (11) of the second component (10) via an axial screw connection (15), wherein the first component (9) can be displaced relative to the second component (10) in a direction of the tube axis.

14. Cryostat configuration according to any one of the claims 6 through 13, **characterized in that** a guiding sleeve (13) is disposed around the first component (9) of the actuator (7) which is rigidly supported on the first component (9) and which has an outer diameter which is large enough to leave play between the guiding sleeve (13) and the second component (10).

15. Cryostat configuration according to any one of the claims 11 through 14, **characterized in that** the second component (10) of the actuator (7), which is designed as tube or channel, is rigidly connected at or close to its open tube end (12) to the cryocontainer (1), which is to be centered relative to the container which is disposed further outside, at a contact point (A) preferably in the vicinity of the outer edge of the cryocontainer (1).

16. Cryostat configuration according to any one of the claims 6 through 15, **characterized in that** the first component (9) of the actuator (7) is rigidly connected to the centering element (4) at one end which is not connected to the second component (10).

17. Cryostat configuration according to any one of the claims 6 through 15, **characterized in that** the actuator (7) additionally comprises a mechanical translating element (17), in particular a lever (18), a toothed wheel or an eccentric, wherein the translating element (17) is rigidly connected to the cryocontainer (1) to be centered at a contact point (A') in the vicinity of the outer edge of the cryocontainer (1), and which contacts the first component (9) either indirectly via a further rod (19) or directly at that end of the first component (9) which is not connected to the second component (10).

18. Cryostat configuration according to claim 17, **characterized in that** the end of the first component (9) of the actuator (7) which is in direct or indirect contact with the mechanical translating element (17) experiences a defined relative motion relative to the translating element (17), wherein the translating element (17) translates this relative motion to the centering element (4) in such a manner that its mechanical tension state is approximately independent of the instantaneous temperatures within the cryostat configuration.

19. Cryostat configuration according to any one of the claims 1 through 5, **characterized in that** the actuator (7') comprises a tube or rod (20) with an arbitrary cross-section, in particular variable cross-section, whose thermal expansion coefficient is smaller or larger than that of the cryocontainer (1) to be centered, and a mechanical translating element (17, 17'), in particular a lever (18, 18'), a toothed wheel or an eccentric.

20. Cryostat configuration according to claim 19, **characterized in that** the mechanical translating element (17, 17') of the actuator (7') is rigidly connected to the cryocontainer (1) to be centered, at a contact point (A') in the vicinity of the outer edge of the cryocontainer (1).

21. Cryostat configuration according to one of the claims 19 or 20, **characterized in that** one end of the tube or rod (20) of the actuator (7') is rigidly connected to the cryocontainer (1) to be centered, at a contact point (B) in the vicinity of the axis (z) of the cryocontainer (1).

22. Cryostat configuration according to claim 21, **characterized in that** the tube or rod (20) of the actuator (7') can be axially displaced at one end which is connected at the contact point (B) to the cryocontainer (1) via an axial screw connection (15), and is guided in the direction of the tube axis via a guiding device (21) which is rigidly connected to the cryocontainer (1) in the vicinity of its other end opposite to the screw connection (15).

23. Cryostat configuration according to any one of the claims 19 through 22, **characterized in that** the other end of the tube or rod (20) in the actuator (7') which contacts the mechanical translating element (17, 17') directly or indirectly via a further rod (19), experiences a defined relative motion relative to the translating element (17, 17'), wherein the translating element (17, 17') translates this relative motion to the centering element (4) such that its mechanical tension state is approximately independent of the instantaneous temperatures within the cryostat configuration.

24. Cryostat configuration according to any one of the preceding claims, **characterized in that** one of the cryocontainers (1) with cryogenic fluid contains a superconducting magnet configuration.

25. Cryostat configuration according to claim 24, **characterized in that** the superconducting magnet configuration is part of an apparatus for nuclear magnetic resonance, in particular magnetic resonance imaging (MRI) or magnetic resonance spectroscopy (NMR).

## Revendications

1. Dispositif cryostatique pour stocker des fluides cryogéniques dans au moins un réservoir cryogénique (1), lequel est suspendu à des tubes de suspension (2) et/ou des dispositifs de suspension thermo-isolants qui sont reliés à une enveloppe extérieure (3) du dispositif cryostatique, ledit au moins un réservoir cryogénique (1) étant centré à l'aide d'au moins trois éléments de centrage (4) répartis sur la circonférence du réservoir cryogénique (1) par rapport à un réservoir situé plus loin vers l'extérieur, de préférence par rapport à l'enveloppe extérieure (3), les éléments de centrage (4) étant appliqués ou fixés par une extrémité (5) sur le réservoir situé plus loin vers l'extérieur,

**caractérisé en ce**

**que** sur au moins un des réservoirs cryogéniques (1), les éléments de centrage (4) sont reliés par leurs extrémités (6) éloignées de l'enveloppe extérieure (3) respectivement à un actionneur (7) qui exerce sur l'élément de centrage (4) concerné une force de pression ou de traction et qui est monté sur le réservoir cryogénique (1) à au moins un point de contact (A, A', B, B'),

les coefficients de dilatation thermique et les dimensions des éléments de l'actionneur (7) étant choisis de manière que, du fait de la fixation de l'actionneur (7) au point de contact (A, A', B, B') sur le réservoir cryogénique (1) ainsi que du fait de variations d'origine thermique des dimensions du réservoir cryogénique (1) et de variations d'origine thermique des dimensions de différents composants de l'actionneur (7) et, le cas échéant, du fait d'une transmission mécanique, on produit une tension mécanique dans les éléments de centrage (4) correspondants, de sorte que les éléments de centrage (4) sont, indépendamment des températures à l'intérieur du dispositif cryostatique, toujours soumis à une pression ou traction quasiment constante, de préférence dans la plage de ± 10 % de la pression ou de la traction qui règne à température ambiante.

2. Dispositif cryostatique selon la revendication 1, **caractérisé en ce que** le réservoir cryogénique (1) présente une ouverture (8) supplémentaire asymétrique vers l'extérieur.

3. Dispositif cryostatique selon l'une des revendications précédentes, **caractérisé en ce qu'**au moins un des éléments de centrage (4) est en contact thermique via un élément de liaison (16) bon conducteur de la chaleur et flexible avec un autre réservoir cryogénique ou un écran anti-radiation (14) qui se trouve entre le réservoir cryogénique (1) à centrer et le réservoir situé plus loin vers l'extérieur.

4. Dispositif cryostatique selon l'une des revendications précédentes, **caractérisé en ce que** les éléments de centrage (4) sont réalisés en matière plastique renforcée par fibres de verre ou dans un matériau possédant des propriétés thermiques et mécaniques analogues.

**5.** Dispositif cryostatique selon l'une des revendications précédentes, **caractérisé en ce que** les éléments de centrage (4) sont réalisés sous la forme de tubes ou de barres de section quelconque, en particulier variable.

**6.** Dispositif cryostatique selon l'une des revendications précédentes, **caractérisé en ce que** l'actionneur (7) comprend un premier (9) et un deuxième composant (10), les composants (9, 10) étant réalisés dans des matériaux possédant différents coefficients de dilatation.

**7.** Dispositif cryostatique selon la revendication 6, **caractérisé en ce que** le premier composant (9) de l'actionneur (7) est réalisé dans un matériau ayant un coefficient de dilatation thermique qui est inférieur ou égal à 0.

**8.** Dispositif cryostatique selon la revendication 6, **caractérisé en ce que** le premier composant (9) de l'actionneur (7) est réalisé dans un matériau ayant un coefficient de dilatation thermique positif dont la valeur est choisie de manière que, lors d'une variation de température, la variation absolue de longueur du premier composant (9) soit inférieure à la variation absolue de longueur du deuxième composant (10), de préférence au maximum égale à un cinquième de la variation absolue de longueur du deuxième composant (10).

**9.** Dispositif cryostatique selon l'une des revendications 6 à 8, **caractérisé en ce que** le premier composant (9) de l'actionneur (7) est réalisé sous la forme d'un tube ou d'une barre de section quelconque, en particulier variable.

**10.** Dispositif cryostatique selon l'une des revendications 6 à 9, **caractérisé en ce que** le deuxième composant (10) de l'actionneur (7) est réalisé dans un matériau ayant un grand coefficient de dilatation thermique positif, en particulier en cuivre, laiton, aluminium ou un matériau possédant des propriétés thermiques et mécaniques analogues.

**11.** Dispositif cryostatique selon l'une des revendications 6 à 10, **caractérisé en ce que** le deuxième composant (10) de l'actionneur (7) est réalisé sous la forme d'un tube fermé d'un côté ou d'un canal fermé d'un côté.

**12.** Dispositif cryostatique selon l'une des revendications 6 à 11, **caractérisé en ce que** le premier composant (9) de l'actionneur (7) est disposé à l'intérieur du deuxième composant (10) de l'actionneur (7) réalisé sous la forme d'un tube ou d'un canal, en particulier coaxialement.

**13.** Dispositif cryostatique selon l'une des revendications 11 ou 12, **caractérisé en ce que** le premier composant (9) de l'actionneur (7) est relié au deuxième composant (10) de l'actionneur (7) réalisé sous forme de tube ou de canal de manière déplaçable au moyen d'une liaison vissée axiale (15) au niveau de l'extrémité de tube fermée (11) du deuxième composant (10), de manière que le premier composant (9) puisse être déplacé par rapport au deuxième composant (10) dans la direction de l'axe du tube.

**14.** Dispositif cryostatique selon l'une des revendications 6 à 13, **caractérisé en ce qu'**autour du premier composant (9) de l'actionneur (7) est placée une douille de guidage (13) qui est montée de manière fixe sur le premier composant (9) et dont le diamètre extérieur est assez grand pour qu'il subsiste un jeu entre la douille de guidage (13) et le deuxième composant (10).

**15.** Dispositif cryostatique selon l'une des revendications 11 à 14, **caractérisé en ce que** le deuxième composant (10) de l'actionneur (7) réalisé sous forme de tube ou de canal est relié de manière fixe ou permanente au niveau ou à proximité de son extrémité de tube ouverte (12) au réservoir cryogénique (1) à centrer par rapport au réservoir situé plus loin vers l'extérieur à un point de contact (A), de préférence à proximité du bord extérieur du réservoir cryogénique (1).

**16.** Dispositif cryostatique selon l'une des revendications 6 à 15, **caractérisé en ce que** le premier composant (9) de l'actionneur (7) est relié de manière fixe ou permanente à l'élément de centrage (4) par une extrémité qui n'est pas reliée au deuxième composant (10).

**17.** Dispositif cryostatique selon l'une des revendications 6 à 15, **caractérisé en ce que** l'actionneur (7) comprend en plus un élément de transmission mécanique (17), en particulier un levier (18), une roue dentée ou un excentrique, lequel est relié de manière fixe ou permanente au réservoir cryogénique (1) à centrer à un point de contact (A') situé à proximité du bord extérieur du réservoir cryogénique (1), et lequel est en contact avec le premier composant (9) indirectement par l'intermédiaire d'une autre barre (19) ou directement à l'extrémité du premier composant (9) qui n'est pas reliée au deuxième composant (10).

**18.** Dispositif cryostatique selon la revendication 17, **caractérisé en ce que** l'extrémité du premier composant (9) de l'actionneur (7) qui est en contact direct ou indirect avec l'élément de transmission mécanique (17) subit un mouvement relatif défini par rapport à l'élément de transmission (17), de sorte que l'élément de transmission (17) transmet ce mouvement relatif à l'élément de centrage (4) de manière que son état de tension mécanique soit approximativement indépendant des températures qui règnent à ce moment à l'intérieur du dispositif cryostatique.

19. Dispositif cryostatique selon l'une des revendications 1 à 5, **caractérisé en ce que** l'actionneur (7') est un tube ou une barre (20) de section quelconque, en particulier variable, dont le coefficient de dilatation thermique est inférieur ou supérieur à celui du réservoir cryogénique (1) à centrer, et comprend un élément de transmission mécanique (17, 17'), en particulier un levier (18, 18'), une roue dentée ou un excentrique.

20. Dispositif cryostatique selon la revendication 19, **caractérisé en ce que** l'élément de transmission mécanique (17, 17') de l'actionneur (7') est relié de manière fixe ou permanente au réservoir cryogénique (1) à centrer à un point de contact (A') situé à proximité du bord extérieur du réservoir cryogénique (1).

21. Dispositif cryostatique selon l'une des revendications 19 à 20, **caractérisé en ce que** le tube ou la barre (20) de l'actionneur (7') est relié(e) de manière fixe ou permanente par une extrémité au réservoir cryogénique (1) à centrer à un point de contact (B) situé à proximité de l'axe (z) du réservoir cryogénique (1).

22. Dispositif cryostatique selon la revendication 21, **caractérisé en ce que** le tube ou la barre (20) de l'actionneur (7') peut être déplacé(e) axialement par l'intermédiaire d'une liaison vissée axiale (15) à son extrémité qui est reliée au réservoir cryogénique (1) par le point de contact (B) et est guidé(e) en direction de l'axe du tube par l'intermédiaire d'un dispositif de guidage (21) relié de manière fixe au réservoir cryogénique (1) à proximité de son autre extrémité, opposée à la liaison vissée (15).

23. Dispositif cryostatique selon l'une des revendications 19 à 22, **caractérisé en ce que** l'autre extrémité du tube ou de la barre (20) dans l'actionneur (7') qui est en contact direct ou indirect avec l'élément de transmission mécanique (17, 17') par l'intermédiaire d'une autre barre (19) subit un mouvement relatif défini par rapport à l'élément de transmission (17, 17'), de sorte que l'élément de transmission (17, 17') transmet ce mouvement relatif à l'élément de centrage (4) de manière que son état de tension mécanique soit approximativement indépendant des températures qui règnent à ce moment à l'intérieur du dispositif cryostatique.

24. Dispositif cryostatique selon l'une des revendications précédentes, **caractérisé en ce qu'**un des réservoirs cryogéniques (1) rempli de fluide cryogénique contient un dispositif magnétique supraconducteur.

25. Dispositif cryostatique selon la revendication 24, **caractérisé en ce que** le dispositif magnétique supraconducteur fait partie d'un appareillage de résonance magnétique nucléaire, en particulier d'imagerie par résonance magnétique (IRM) ou de spectroscopie par résonance magnétique (RMN).

**Fig. 1a**

**Fig. 1b**

**Fig. 2a**

**Fig. 2b**

17

**Fig. 3a**

**Fig. 3b**

**Fig. 4a**

**Fig. 4b**

**Fig. 4c**

**Fig. 5a**

**Fig. 5b**

**Fig. 5c**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0014250 A
- DE 2906060 A1
- US 20020002830 A